# EUROPÄISCHE PATENTANMELDUNG

(11) **EP 2 793 339 A1**
(43) Veröffentlichungstag der Anmeldung: **22.10.2014**
(21) Anmeldenummer: 14160417.3
(22) Anmeldetag: 18.03.2014
(51) Int. Cl.: H02H 3/33

(54) **Allstromsensitive Fehlerstrom-Schutzeinrichtung (RCD) mit Parameterkonfiguration**

(30) Priorität: 19.04.2013 DE 102013207141
(71) Anmelder: Bender GmbH & Co. KG, 35305 Grünberg (DE)
(72) Erfinder: Kammer, Michael, 35410 Hungen (DE)
(74) Vertreter: advotec.

(57) **Zusammenfassung**

Die Erfindung betrifft eine Fehlerstrom-Schutzeinrichtung (RCD) und ein Verfahren zur allstromsensitiven Differenzstrommessung mit einer spannungsabhängigen Funktionseinheit, die eine allstromsensitive Differenzstrommesseinrichtung, bestehend aus einem Stromsensor und einem allstromsensitiven Stromerfassungsmodul, sowie einen Mikrocontroller zur Konfiguration der spannungsabhängigen Funktionseinheit und zur Auswertung des von der allstromsensitiven Differenzstrommesseinrichtung erfassten Differenzstroms aufweist.

## Beschreibung

Die Erfindung betrifft eine Fehlerstrom-Schutzeinrichtung (RCD) zur allstromsensitiven Differenzstrommessung mit den Merkmalen gemäß dem jeweiligen Oberbegriff der Ansprüche 1 und 4.

Weiterhin betrifft die Erfindung ein Verfahren zur allstromsensitiven Differenzstrommessung mit den Merkmalen gemäß dem jeweiligen Oberbegriff der Ansprüche 13 und 16.

Als Schutztechnik bei elektrischen Anlagen zum Schutz bei Berühren von Körpern elektrischer Betriebsmittel sind Fehlerstrom-Schutzeinrichtungen (RCDs - residual current protective device) hinlänglich bekannt und als Schutzmaßnahme in speziellen Bereichen elektrischer Anlagen normativ vorgeschrieben.

Die Wirkungsweise einer derartigen Fehlerstrom-Schutzeinrichtung (RCD) beruht auf der Tatsache, dass im fehlerfreien Betrieb einer elektrischen Anlage die vektorielle Summe der Ströme auf allen stromführenden Leitern einer Zuleitung gleich Null ist und keine Induktion in einem Magnetkern der Fehlerstrom-Schutzeinrichtung (RCD) erzeugt wird. Entsteht auf Grund eines Isolationsfehlers ein Fehlerstrom, der außerhalb der Zuleitung über einen Körper bzw. über Erde abfließt, ergibt sich ein Differenzstrom. Über das veränderliche Magnetfeld dieses Differenzstroms wird sekundärseitig ein Strom induziert, der einen Leistungsschalter auslöst, welcher die fehlerbehaftete Zuleitung trennt.

In einfachster, ursprünglicher Variante ist eine Fehlerstrom-Schutzeinrichtung (RCD) auf Grund des Induktionsprinzips nur in der Lage, zeitliche Änderungen des magnetischen Flusses und damit in der Praxis nur reine Wechselfehlerströme bzw. Wechseldifferenzströme zu detektieren. An die elektrische Anlage angeschlossene Verbraucher wie beispielsweise elektrische Maschinen, die elektronische Halbleiterbauelemente wie Dioden oder Thyristoren in Gleichrichtern oder Frequenzumrichtern aufweisen, können allerdings auch Fehlerströme erzeugen, die einen nicht rein sinusförmigen, sondern einen pulsierenden zeitlichen Verlauf besitzen. Daher sind Fehlerstrom-Schutzeinrichtungen (RCDs) konzipiert worden, die in der Lage sind, neben reinen Wechselfehlerströmen auch phasenangeschnittene Ströme und pulsierende Gleichfehlerströme zu erfassen. Derartige pulsstromsensitive Fehlerstrom-Schutzeinrichtungen (RCDs) werden auch als Fehlerstrom-Schutzeinrichtungen (RCDs) Typ A bezeichnet. Darüber hinaus existieren allstromsensitive Fehlerstrom-Schutzeinrichtungen (RCDs) vom Typ B, die zusätzlich auch glatte Gleichfehlerströme erkennen.

Jede der durch die unterschiedlichen Fehlerstromarten bestimmten Auslösecharakteristiken erfordert eine spezifische Gerätevariante, wobei der Auslösewert und die Zeitverzögerung als weitere Funktionsparameter nach normativen Vorgaben festgelegt sind. Dies führt zu einer großen Typenvielfalt verbunden mit hohen Herstellungskosten.

Als weiterer Nachteil der nach dem Stand der Technik bekannten Fehlerstrom-Schutzeinrichtungen erweist sich, dass zwar eine regelmäßige Funktionsprüfung mittels einer Prüfeinrichtung durch manuelles Auslösen einer Testtaste herstellerseitig empfohlen wird, diese Empfehlung erfahrungsgemäß aber von den Anlagenbetreibern selten eingehalten wird.

Es existieren keine Fehlerstrom-Schutzeinrichtungen, die über eine Möglichkeit zur Datenübertragung verfügen und damit systemfähig wären. Auch besitzt keine der auf dem Markt verfügbaren Fehlerstrom-Schutzeinrichtungen die Möglichkeit, den ermittelten Fehlerstrom-Messwert, beispielsweise zu Kontrollzwecken, darzustellen oder den Anlagenbetreiber auf eine schleichende Zunahme des Fehlerstroms hinzuweisen.

Der vorliegenden Erfindung liegt somit die Aufgabe zu Grunde, eine Fehlerstrom-Schutzeinrichtung (RCD) zur allstromsensitiven Differenzstrommessung zu entwickeln, deren Herstellungsaufwand mit möglichst geringen Kosten verbunden ist und die sich im Betrieb als zuverlässig und vielseitig einsetzbar erweist.

Weiterhin besteht die Aufgabe der Erfindung in der Bereitstellung eines im Sinne der Entwicklungsziele für die Fehlerstrom-Schutzeinrichtung implementierbaren Verfahrens zur allstromsensitiven Differenzstrommessung.

Die Aufgabe wird in Verbindung mit den Merkmalen des Oberbegriffs von Anspruch 1 gelöst durch eine spannungsabhängige Funktionseinheit mit einer allstromsensitiven Differenzstrommesseinrichtung, bestehend aus einem Stromsensor und einem allstromsensitiven Stromerfassungsmodul, und mit einem Mikrocontroller zur Konfiguration der spannungsabhängigen Funktionseinheit und zur Auswertung des von der allstromsensitiven Differenzstrommesseinrichtung erfassten Differenzstroms.

Neben einer bekannten spannungsunabhängigen, pulsstromsensitiven Differenzstrommesseinrichtung, die einen Messstromwandler, einen Leistungsschalter und eine Prüfeinrichtung aufweist, umfasst die Fehlerstrom-Schutzeinrichtung erfindungsgemäß eine spannungsabhängige Funktionseinheit mit einem Mikrocontroller. Diese spannungsabhängige Funktionseinheit kann innerhalb der Fehlerstrom-Schutzeinrichtung (RCD) als RCD-Modul zur Erfassung allstromsensitiver Fehlerströme aufgefasst werden. Dazu weist diese Funktionseinheit eine aus einem Stromsensor und einem allstromsensitiven Stromerfassungsmodul bestehende Differenzstromeinrichtung auf, wobei der Stromsensor die Leiterströme der zu überwachenden Leitung erfasst und in einen Sekundärstrom transformiert, der von dem allstromsensitiven Erfassungsmodul in eine von dem Mikrocontroller auswertbare Spannung umgesetzt wird.

Der in die spannungsabhängige Funktionseinheit integrierte Mikrocontroller erlaubt die Konfiguration und Parametrierung hinsichtlich des Auslöseverhaltens dieses spannungsabhängigen RCD-Moduls, d.h. die Auslösecharakteristik kann durch Festlegen der Funktionsparameter wie beispielsweise Auslösewert oder Zeitverzögerung dem Anwendungsfall entsprechend parametriert werden. Da somit ein universell einsetzbares RCD-Modul für eine Fehlerstrom-Schutzeinrichtung (RCD) geschaffen wird, verringert sich die Typenvielfalt erforderlicher Fehlerstrom-Schutzeinrichtungen (RCD) einhergehend mit einer Kostenreduktion im Fertigungsprozess und verbunden mit einer Verringerung des logistischen Aufwands.

Der Mikrocontroller übernimmt die Aufgabe der Auswertung des von der allstromsensitiven Differenzstrommesseinrichtung erfassten Differenzstroms. Bestandteil dieser Auswertung kann die Berechnung des Effektivwertes sein, wobei ein Ergebnis dieser Auswertung neben der Erkennung einer Überschreitung der Auslöseschwelle auch eine Vorwarnung im Hinblick auf ein bevorstehendes Überschreiten der Auslöseschwelle sein kann.

Die vorgenannten Merkmale des Anspruchs 1 geben den Aufbau der Fehlerstrom-Schutzeinrichtung (RCD) für eine Ausführungsform nach Anspruch 2 (Variante 1) und für eine Ausführungsform nach Anspruch 3 (Variante 2) vor.

In einer ersten Ausgestaltung (Variante 1) ist die Prüfeinrichtung zum Test der spannungsunabhängigen, pulsstromsensitiven Differenzstrommesseinrichtung als separate, manuell auslösbare Prüfeinrichtung mit einer Prüftaste und einem Prüfwiderstand ausgebildet, wohingegen die spannungsabhängige Funktionseinheit eine gesteuerte Prüfeinrichtung zum Test der allstromsensitiven Differenzstrommesseinrichtung aufweist.

Die Fehlerstrom-Schutzeinrichtung (RCD) umfasst somit neben der manuell auslösbaren Prüfeinrichtung für die pulsstromsensitive Differenzstrommesseinrichtung eine weitere, gesteuerte Prüfeinrichtung zum Test der allstromsensitiven Differenzstrommesseinrichtung innerhalb der spannungsabhängigen Funktionseinheit. Die manuell auslösbare Prüfeinrichtung besteht dabei aus einer Prüftaste und einem Prüfwiderstand, wohingegen die gesteuerte Prüfeinrichtung über den Mikrocontroller automatisch zu bestimmten Zeitpunkten oder in periodischen Zeitabständen, z.B. einmal täglich, oder über eine Bedieneinheit ebenfalls manuell aktiviert werden kann. Dabei kann die gesteuerte Prüfung über den Test der rein mechanischen Funktion hinaus eine vollständige Funktionsprüfung entsprechend der parametrierten Auslösecharakteristik vornehmen, wobei das Testsignal aus der Überlagerung eines Gleich- und eines Wechselstroms besteht und durch die Sekundärwicklung (Prüfwicklung) des Stromsensors der allstromsensitiven Differenzstrommesseinrichtung geleitet wird. Bei fehlgeschlagener Prüfung löst der Leistungsschalter aus.

In einer alternativen Ausgestaltung (Variante 2) weist die Fehlerstrom-Schutzeinrichtung (RCD) eine gemeinsame, gesteuerte Prüfeinrichtung zum Test der spannungsunabhängigen, pulsstromsensitiven Differenzstrommesseinrichtung und zum Test der allstromsensitiven Differenzstrommesseinrichtung auf.

Diese Variante 2 unterscheidet sich damit von der Variante 1 durch eine Prüfeinrichtung, die sowohl die spannungsabhängige, pulsstromsensitive

Differenzstromeinrichtung außerhalb der spannungsabhängigen Funktionseinheit als auch die allstromsensitive Differenzstromeinrichtung innerhalb der spannungsabhängigen Funktionseinheit überprüft. Hierzu wird wiederum ein Testsignal mit einer Gleich- und einer Wechselstromkomponente erzeugt, das über die Prüfwicklungen der Stromsensoren (Messstromwandler) der beiden Differenzstrommesseinrichtungen fließt. In vorteilhafter Weise entfällt somit eine separate Prüfeinrichtung zum Test der spannungsunabhängigen Differenzstrommesseinrichtung. Analog zu Variante 1 kann eine vollständige Funktionsprüfung entweder durch manuelle Betätigung der Bedieneinheit eingeleitet oder automatisch zu bestimmten Zeitpunkten ausgeführt werden.

Die gestellte Aufgabe wird in Verbindung mit den Merkmalen des Oberbegriffs von Anspruch 4 durch eine weitere Ausführung (Variante 3) gelöst, die gekennzeichnet ist durch eine spannungsabhängige Funktionseinheit mit einer allstromsensitiven Differenzstrommesseinrichtung, bestehend aus einem Stromsensor und einem allstromsensitiven Stromerfassungsmodul, und mit einem Mikrocontroller zur Konfiguration der spannungsabhängigen Funktionseinheit und zur Auswertung des von der allstromsensitiven Differenzstrommesseinrichtung erfassten Differenzstroms, wobei die spannungsabhängige Funktionseinheit eine gesteuerte Prüfeinrichtung zum Test der allstromsensitiven Differenzstrommesseinrichtung aufweist.

In dieser Variante wird vollständig auf die spannungsunabhängige Differenzstrommesseinrichtung verzichtet, die in den Varianten 1 und 2 nur deshalb vorhanden ist, da die derzeitige Normung in Deutschland diese Funktionalität fordert. Die Ausführungsform nach Variante 3 entspricht daher im Wesentlichen der spannungsabhängigen Funktionseinheit (RCD-Modul) zur allstromsensitiven Differenzstrommessung mit einem Leistungsschalter. Die spannungsabhängige Funktionseinheit weist wie die Varianten 1 und 2 neben der allstromsensitiven Differenzstromeinrichtung einen Mikrocontroller auf und bietet somit sämtliche Vorteile der vorgenannten Varianten. Damit ist diese versorgungsspannungsabhängige Ausführungsform hinsichtlich der Auslösecharakteristik, insbesondere des Auslösewertes und der Zeitverzögerung vollständig parametrierbar.

Alle Varianten besitzen die nachfolgend aufgeführten vorteilhaften Ausgestaltungsmerkmale.

Die spannungsabhängige Funktionseinheit weist eine digitale Programmierschnittstelle zur Voreinstellung von Konfigurationsparametern während des Herstellungsprozesses der Fehlerstrom-Schutzeinrichtung (RCD) auf. Über diese Programmierschnittstelle können die Auslösecharakteristik, der Auslösewert sowie die Zeitverzögerung der spannungsabhängigen, allstromsensitiven Differenzstrommesseinrichtung während des Herstellungsprozesses voreingestellt werden. Damit trägt diese Ausgestaltung weiter zu einer Verringerung der Typenvielfalt bei und führt zu einer weitergehenden Kostenreduktion bei verringertem logistischem Aufwand. Die versorgungsspannungsunabhängige Differenzstrommesseinrichtung (nur in den Varianten 1 und 2 vorhanden) dagegen ist nicht parametrierbar.

In weiterer vorteilhafter Ausgestaltung weist die spannungsabhängige Funktionseinheit eine digitale Kommunikationsschnittstelle zur Datenübertragung auf. Die digitale Kommunikationsschnittstelle bietet die Möglichkeit einer Datenübertragung im Feldbetrieb, wobei die Daten sowohl Funktionsparameter sein können, also eine Konfiguration bzw. eine Parametrierung der Auslösecharakteristik im Feld erlauben - was allerdings nach derzeitiger Normgebung nicht zulässig ist -, als auch Betriebs- oder Messdaten sein können. Beispielsweise ist ein Datenaustausch mit einer zentralen Leitstelle zum Zweck der Messwertübermittlung oder die Übermittlung von Betriebsdaten zu Wartungszwecken möglich. Der Anlagenzustand kann somit zentral überwacht werden. Die Datenübertragung über die digitale Kommunikationsschnittstelle kann zu programmierbaren Zeitpunkten erfolgen, z.B. im Rahmen eines Funktionstests, wobei diese Prüfung auch eine Auslösung des Leistungsschalters umfasst. Über die digitale Kommunikationsschnittstelle kann die Fehlerstrom-Schutzeinrichtung (RCD) an die in unterschiedlichen Anwendungssituationen geltenden Anforderungen angepasst werden und somit weiter zu einer Aufwandsreduktion beitragen.

Mit Vorteil weist die spannungsabhängige Funktionseinheit eine Anzeigeeinrichtung zur Darstellung des erfassten Differenzstroms auf. Die Anzeigeeinrichtung zeigt lokal den Wert des von der allstromsensitiven Differenzstrommesseinrichtung erfassten Differenzstroms an und gibt damit Auskunft über den aktuellen Isolationszustand der elektrischen Anlage. Aus dieser Information ist durch Vergleich mit dem in dem Konfigurationsprozess eingestellten Auslösewert erkennbar, ob für die überwachte Anlage die Gefahr besteht, dass eine Abschaltung durch Auslösen des Leistungsschalters auf Grund einer (Grenzwert-)Überschreitung bevorsteht.

Weiterhin weist die spannungsabhängige Funktionseinheit eine Stromquelle zur Bereitstellung eines Teststroms für die gesteuerte Prüfeinrichtung in den Varianten 1 und 3 oder für die gemeinsame gesteuerte Prüfeinrichtung in Variante 2 auf. Die Stromquelle ermöglicht im Rahmen der manuellen oder automatisierten Auslösung die Funktionsprüfung der allstromsensitiven Differenzstrommesseinrichtung der spannungsabhängigen Funktionseinheit entsprechend der parametrierten Auslösecharakteristik.

Des Weiteren besitzt die spannungsabhängige Funktionseinheit eine Bedieneinheit zur Eingabe von Daten und zur manuellen Ablaufsteuerung. Die Bedieneinheit ermöglicht unter anderem die manuelle Einleitung einer Funktionsprüfung sowie die Parametrierung im Feldbetrieb-allerdings ist letztere Vorgehensweise nach derzeitiger Normenlage nicht zulässig.

Die spannungsabhängige Funktionseinheit weist eine Treiberschaltung und eine Schaltstufe zur Weiterleitung eines Auslösesignals an den Leistungsschalter auf. Überschreitungen des Auslösewertes werden somit in Form eines Auslösesignals über die Treiberschaltung und die Schaltstufe an den Leistungsschalter geleitet, der die Last und damit die Fehlerstelle spannungsfrei schaltet.

Von Vorteil ist, wenn die spannungsabhängige Funktionseinheit Signalisierungseinrichtungen zur Signalisierung von Warnungen und Betriebszuständen aufweist. Derartige Signalisierungseinrichtungen können als optische und/oder akustische Einrichtungen ausgeführt sein und beispielsweise den Auslösezustand oder zuvor bei Überschreitung eines Grenzwertes unterhalb des Auslösewertes eine Vorwarnung ausgeben.

Vorzugsweise besitzt die spannungsabhängige Funktionseinheit einen Schaltsignalausgang zur Ausgabe mindestens eines programmierbaren Schaltsignals. Über diesen Schaltsignalausgang ist es beispielsweise möglich, bei Überschreitung eines Grenzwertes unterhalb des Auslösewertes eine Vorwarnung in Form eines weiterverarbeitbaren Schaltsignals auszugeben, um damit notwendige Instandsetzungsarbeiten vor Auslösen des Leistungsschalters einleiten zu können.

Bezogen auf ein Verfahren wird die Aufgabe in Verbindung mit dem Oberbegriff des Anspruchs 13 dadurch gelöst, dass eine allstromsensitive Differenzstrommessung durch eine spannungsabhängige Funktionseinheit mit einer allstromsensitiven Differenzstrommesseinrichtung erfolgt und mittels eines Mikrocontrollers eine Konfiguration der spannungsabhängigen Funktionseinheit sowie eine Auswertung des von der allstromsensitiven Differenzstrommesseinrichtung erfassten Differenzstroms ausgeführt werden.

Korrespondierend zu der in dem Vorrichtungsanspruch 1 definierten Fehlerstrom-Schutzeinrichtung (RCD) liegt dem beanspruchten Verfahren gemäß Anspruch 13 die Idee zu Grunde, neben einer normativ vorgeschriebenen, spannungsunabhängigen, pulsstromsensitiven Differenzstrommessung, eine allstromsensitive Differenzstrommessung in einer spannungsabhängigen Funktionseinheit durchzuführen und mittels eines Mikrocontrollers die Konfiguration und Parametrierung hinsichtlich des Auslöseverhaltens sowie die Auswertung des von der allstromsensitiven Differenzstrommesseinrichtung erfassten Differenzstroms vornehmen zu können.

Analog zu der oben beschriebenen Variante 1 beruht das dieser Variante entsprechende Verfahren darauf, dass die Prüfung der spannungsunabhängigen, pulsstromsensitiven Differenzstrommesseinrichtung spannungsunabhängig mittels einer separaten, manuell auslösbaren Prüfeinrichtung erfolgt und dass eine Prüfung der allstromsensitiven Differenzstrommesseinrichtung spannungsabhängig mittels einer gesteuerten Prüfeinrichtung erfolgt.

Alternativ beruht das der oben beschriebenen Variante 2 zu Grunde liegende Verfahren darauf, dass eine gemeinsame, spannungsabhängige Prüfung der spannungsunabhängigen, pulsstromsensitiven Differenzstrommesseinrichtung und der allstromsensitiven Differenzstrommesseinrichtung mittels einer gemeinsamen, gesteuerten Prüfeinrichtung erfolgt.

Weiterhin wird die der Erfindung zu Grunde liegende Aufgabe in Verbindung mit dem Oberbegriff des Anspruchs 16 gelöst durch ein zu der oben dargestellten Variante 3 korrespondierendes Verfahren, bei dem eine allstromsensitive Differenzstrommessung durch eine spannungsabhängige Funktionseinheit mit einer allstromsensitiven Differenzstrommesseinrichtung erfolgt und mittels eines Mikrocontrollers eine Konfiguration der spannungsabhängigen Funktionseinheit sowie eine Auswertung des von der allstromsensitiven Differenzstrommesseinrichtung erfassten Differenzstroms ausgeführt werden und wobei eine Prüfung der allstromsensitiven Differenzstrommesseinrichtung spannungsabhängig mittels einer gesteuerten Prüfeinrichtung erfolgt.

Da alle Verfahrensvarianten die Grundlage für die entsprechende Umsetzung der Verfahren in die entsprechende Variante der Fehlerstrom-Schutzeinrichtung (RCD) bilden, treffen die oben ausgeführten Vorteile für die Fehlerstrom-Schutzeinrichtung (RCD) gleichermaßen für die beanspruchten Verfahrensmerkmale zu.

Insbesondere umfasst die Konfiguration der spannungsabhängigen Funktionseinheit eine Einstellung der Funktionsparameter Ansprechwert, Zeitverzögerung sowie eine Parametrierung der Auslösecharakteristik, wodurch eine auf der Anwendung des Verfahrens basierende Fehlerstrom-Schutzeinrichtung (RCD) zur Überwachung unterschiedlicher Fehlerstromarten eingesetzt werden kann.

Die Auswertung des von der allstromsensitiven Differenzstrommesseinrichtung erfassten Differenzstroms mittels des Mikrocontrollers umfasst dabei in zweckmäßiger Weise einen oder mehrere der folgenden Schritte: eine Effektivwertberechnung, einen Schwellwertvergleich mit Erzeugung des Auslösesignals, die Signalisierung von Warnungen und Betriebszuständen, eine Erzeugung und Ausgabe von programmierbaren Schaltsignalen.

Die Berechnung des Effektivwertes führt vorteilhafterweise zu einem Messergebnis, das unabhängig von der Kurvenform des Differenzstroms, also unabhängig von der Art des Fehlerstroms ist.

Die Signalisierung von Warnungen und Betriebszuständen ermöglicht die optische Darstellung des Auslösezustands und der Vorwarnung bei Überschreitung eines Grenzwertes unterhalb der Auslöseschwelle. Eine derartige Vorwarnung bietet dem Anlagenbetreiber die Möglichkeit Instandsetzungsarbeiten durchzuführen, bevor es durch eine weitere Verschlechterung des Isolationszustandes zu einer automatischen Abschaltung der Anlage durch die Fehlerstrom-Schutzeinrichtung (RCD) kommt.

Weitere vorteilhafte Ausgestaltungsmerkmale ergeben sich aus der nachfolgenden Beschreibung und den Zeichnungen, die bevorzugte Ausführungsformen der Erfindung an Hand von Beispielen erläutern. Es zeigen:
- **Fig. 1:**: eine erfindungsgemäße Fehlerstrom-Schutzeinrichtung gemäß Variante 1,
- **Fig. 2:**: eine erfindungsgemäße Fehlerstrom-Schutzeinrichtung gemäß Variante 2 und
- **Fig. 3:**: eine erfindungsgemäße Fehlerstrom-Schutzeinrichtung gemäß Variante 3.

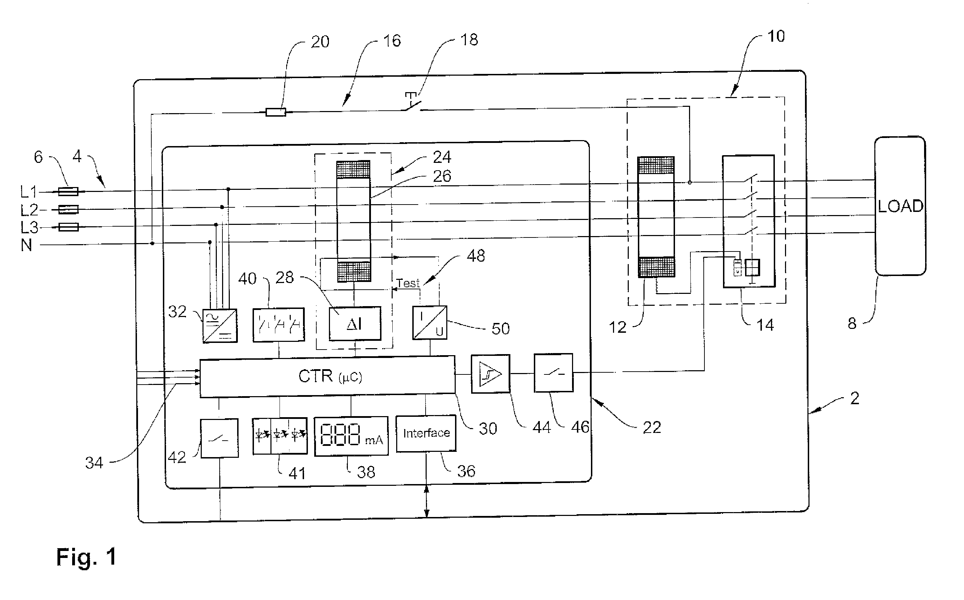

**Fig. 1** zeigt eine erfindungsgemäße Fehlerstrom-Schutzeinrichtung (RCD) 2 gemäß Variante 1, die als Schutzmaßnahme gegen elektrischen Schlag in einem Stromversorgungssystem 4 vorgesehen ist. Das Stromversorgungssystem (4) ist als Dreiphasennetz durch die aktiven Leiter L1, L2, L3 und N dargestellt, die auf der Einspeiseseite durch Überstrom-Schutzeinrichtungen (Sicherungen) 6 abgesichert sind und verbraucherseitig mit einer Last 8 verbunden sind.

Die Fehlerstrom-Schutzeinrichtung (RCD) 2 umfasst eine (versorgungs-)spannungsunabhängige, pulsstromsensitive Differenzstrommesseinrichtung 10, die aus einem Messstromwandler 12, einem Leistungsschalter 14 und einer Prüfeinrichtung 16 mit einer Prüftaste 18 und einem Prüfwiderstand 20 besteht. Zur Erfassung des Differenzstroms umschließt der Messstromwandler 12 die aktiven Leiter L1, L2, L3 und N des Stromversorgungssystems 4. Grundsätzlich ist die Fehlerstrom-Schutzeinrichtung (RCD) in der Lage, beliebige Stromversorgungssysteme wie beispielsweise auch Einphasennetze oder Drehstromnetze ohne Neutralleiter zu überwachen.

Als wesentliche Elemente weist die Fehlerstrom-Schutzeinrichtung (RCD) 2 erfindungsgemäß eine spannungsabhängige Funktionseinheit 22 mit einer allstromsensitiven Differenzstrommesseinrichtung 24 und mit einem Mikrocontroller 30 auf.

Die allstromsensitive Differenzstrommesseinrichtung 24 wiederum besteht aus einem Stromsensor 26 (Messstromwandler) und einem allstromsensitiven Stromerfassungsmodul 28.

Um eine zuverlässige Funktion der spannungsabhängigen Funktionseinheit 22 zu gewährleisten, ist diese allpolig über eine Versorgungseinheit 32 mit dem Stromversorgungssystem 4 verbunden, so dass bei Ausfall einer Phase oder des Neutralleiters die allstromsensitive Schutzfunktion aufrechterhalten bleibt.

Der Mikrocontroller 30 dient zur Konfiguration der spannungsabhängigen Funktionseinheit 22 und zur allstromsensitiven Auswertung des von dem Stromsensor 26 auf den aktiven Leitern L1, L2, L3 und N erfassten Differenzstroms.

Über eine Programmierschnittstelle 34 des Mikrocontrollers 30 kann die Konfiguration bzw. die Parametrierung entsprechend der Messaufgabe durch Einstellung der Funktionsparameter wie Auslösewert, Zeitverzögerung und Auslösecharakteristik bereits während des Herstellungsprozesses der Fehlerstrom-Schutzeinrichtung (RCD) 2 erfolgen. In gleicher Weise kann auch eine Parametrierung im Feldbetrieb über eine Kommunikationsschnittstelle 36 vorgenommen werden. Die Kommunikationsschnittstelle 36 dient weiterhin der Übertragung von Messwerten oder der Übermittlung von Betriebsdaten zu Wartungszwecken.

Zur Anzeige des erfassten Differenzstroms ist eine optische Anzeigeeinrichtung 38 vorgesehen.

Eine Bedieneinheit 40 erlaubt die Eingabe von Daten und ermöglicht eine manuelle Kontrolle der Mess- und Prüfabläufe. So kann die Einleitung einer manuellen Funktionsprüfung oder die Parametrierung im Feldbetrieb über die Bedieneinheit 40 vorgenommen werden.

Weiterhin umfasst die spannungsabhängige Funktionseinheit 22 Signalisierungseinrichtungen 41 zur Signalisierung von Warnungen und Betriebszuständen. Die Signalisierungseinrichtungen 41 dienen beispielsweise zur Anzeige des Auslösezustands und zur Signalisierung der Vorwarnung bei Überschreitung eines Grenzwertes unterhalb der Auslöseschwelle.

Zur Ausgabe von programmierbaren Schaltsignalen weist die spannungsabhängige Funktionseinheit 22 einen Schaltsignalausgang 42 auf. Dieser Schaltsignalausgang 42 kann dazu verwendet werden, ein bei einer Grenzwertüberschreitung erzeugtes Schaltsignal nach außen zu führen, um weitere Maßnahmen automatisch einzuleiten. Beispielsweise kann ein Grenzwert unterhalb der Auslöseschwelle der Fehlerstrom-Schutzeinrichtung (RCD) 2 parametriert werden, so dass der Betreiber der Anlage durch ein Warnsignal darüber informiert wird, dass eine Abschaltung des Leistungsschalters 14 auf Grund eines zu hohen Differenzstromes bevorsteht. Auch eine Ausgabe mehrerer Schaltsignale ist möglich.

Im Fall der Überschreitung des Auslösewertes erfolgt mittels einer Treiberschaltung 44 und einer Schaltstufe 46 eine Weiterleitung des Auslösesignals an den Leistungsschalter 14 um die Last 8 von dem Stromversorgungssystem 4 zu trennen.

Zum Test der allstromsensitiven Differenzstrommesseinrichtung 24 ist eine gesteuerte Prüfeinrichtung 48 mit einer Stromquelle 50 vorgesehen, die die Prüfwicklung des Stromsensors 26 mit einem Teststrom als Prüfsignal speist. Damit kann eine Funktionsprüfung entsprechend der parametrierten Auslösecharakteristik durchgeführt werden, wobei der Teststrom aus der Überlagerung eines Gleich- und eines Wechselanteils besteht.

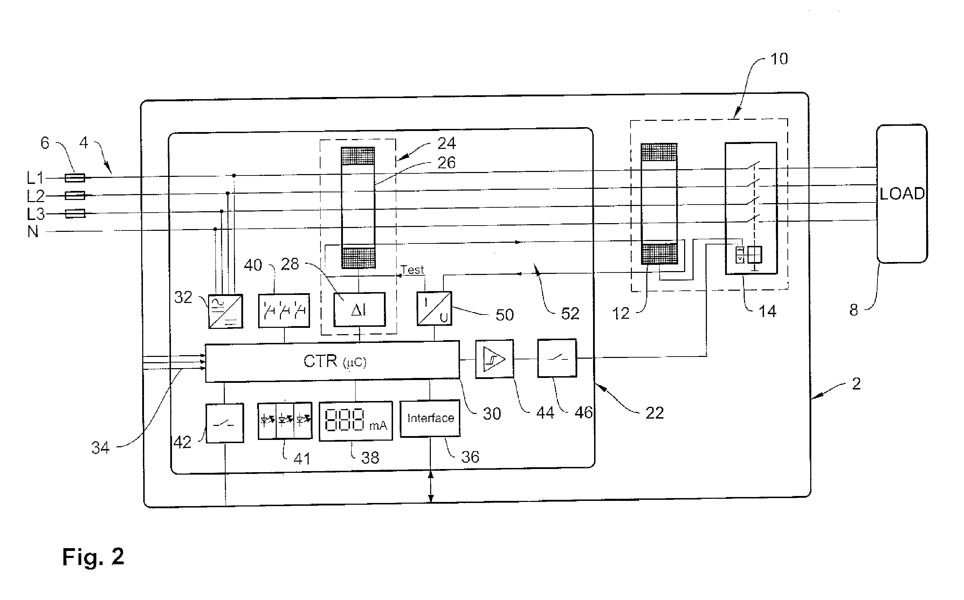

In Fig. 2 ist eine erfindungsgemäße Fehlerstrom-Schutzeinrichtung (RCD) 2 gemäß Variante 2 dargestellt. Von der in Fig. 1 gezeigten Variante 1 unterscheidet sich die Variante 2 lediglich dadurch, dass sie eine gemeinsame, gesteuerte Prüfeinrichtung 52 zum Funktionstest der spannungsunabhängigen, pulsstromsensitiven Differenzstrommesseinrichtung 10 und zum Test der allstromsensitiven Differenzstrommesseinrichtung 24 aufweist. Die gemeinsame, gesteuerte Prüfeinrichtung 52 deckt damit sowohl den passiven Überwachungsteil mit der spannungsunabhängigen Differenzstrommesseinrichtung 10 als auch die aktive Überwachung mit der spannungsabhängigen Differenzstrommesseinrichtung 24 ab. Das von der Stromquelle 50 erzeugte Prüfsignal besteht aus einer Gleich- und einer Wechselstromkomponente und fließt durch die Prüfwicklung des Messstromwandlers 12 der spannungsunabhängigen, pulsstromsensitiven Differenzstrommesseinrichtung 10 und durch die Prüfwicklung des Stromsensors 26 der allstromsensitiven Differenzstrommesseinrichtung 24. Die in Variante 1 vorhandene manuelle Prüfeinrichtung 16 mit der Prüftaste 18 und dem Prüfwiderstand 20 kann daher entfallen. Der Funktionstest kann wie bei Variante 1 durch manuelle Betätigung an der Bedieneinheit 40 oder über den Mikrocontroller 30 gesteuert automatisch zu festgelegten Zeitpunkten, beispielsweise in periodischen Zeitabständen, durchgeführt werden.

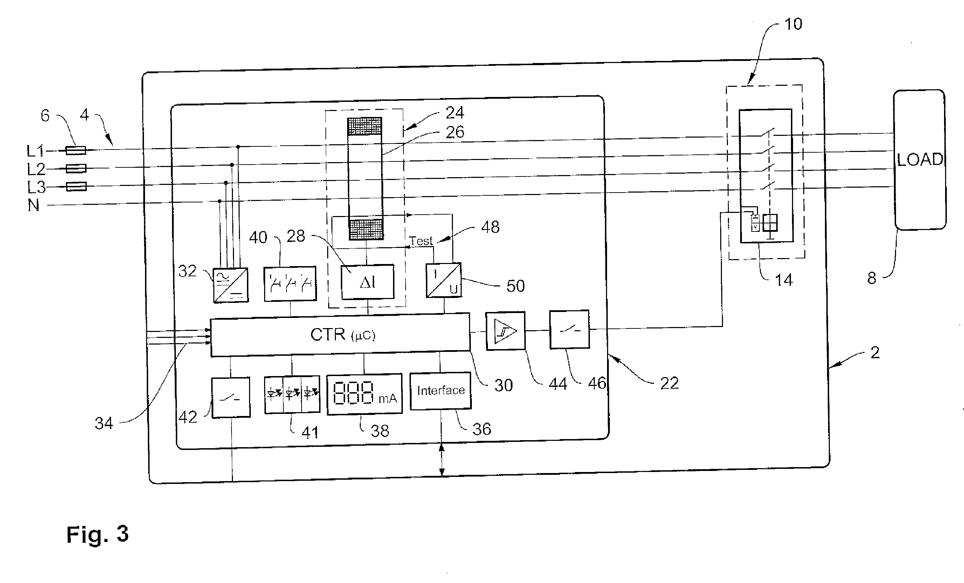

Die **Fig. 3** zeigt eine erfindungsgemäße Fehlerstrom-Schutzeinrichtung gemäß Variante 3, die mit der spannungsabhängigen Funktionseinheit 22 nur einen aktiven, allstromsensitiven Überwachungsteil aufweist. Auf eine spannungsunabhängige Differenzstrommesseinrichtung 10 ist verzichtet worden - diese ist nur deshalb in den Varianten 1 und 2 vorhanden, da die derzeitige Normung diese Funktionalität fordert. Die Variante 3 entspricht damit der Variante 1 ohne die spannungsunabhängige Differenzstrommesseinrichtung 10 und stellt eine versorgungsspannungsabhängige Ausführung einer Fehlerstrom-Schutzschaltung (RCD) dar, deren Funktionsparameter, insbesondere hinsichtlich der Auslösecharakteristik, des Auslösewertes und der Zeitverzögerung vollständig parametrierbar sind.

## Patentansprüche

1. Fehlerstrom-Schutzeinrichtung (RCD) (2) zur allstromsensitiven Differenzstrommessung mit einer spannungsunabhängigen, pulsstromsensitiven Differenzstrommesseinrichtung (10), die einen Messstromwandler (12), einen Leistungsschalter (14) und eine Prüfeinrichtung (16, 52) zum Test der pulsstromsensitiven Differenzstrommesseinrichtung (10) aufweist,
**gekennzeichnet durch**
eine spannungsabhängige Funktionseinheit (22) mit einer allstromsensitiven Differenzstrommesseinrichtung (24), bestehend aus einem Stromsensor (26) und einem allstromsensitiven Stromerfassungsmodul (28), und mit einem Mikrocontroller (30) zur Konfiguration der spannungsabhängigen Funktionseinheit (22) und zur Auswertung des von der allstromsensitiven Differenzstrommesseinrichtung (24) erfassten Differenzstroms.

2. Fehlerstrom-Schutzeinrichtung (RCD) (2) nach Anspruch 1,
**dadurch gekennzeichnet,**
**dass** die Prüfeinrichtung (16) zum Test der spannungsunabhängigen, pulsstromsensitiven Differenzstrommesseinrichtung als separate, manuell auslösbare Prüfeinrichtung (16) mit einer Prüftaste (18) und einem Prüfwiderstand (20) ausgebildet ist und dass die spannungsabhängige Funktionseinheit (22) eine gesteuerte Prüfeinrichtung (48) zum Test der allstromsensitiven Differenzstrommesseinrichtung (24) aufweist.

3. Fehlerstrom-Schutzeinrichtung (RCD) (2) nach Anspruch 1,
**gekennzeichnet durch**
eine gemeinsame, gesteuerte Prüfeinrichtung (52) zum Test der spannungsunabhängigen, pulsstromsensitiven Differenzstrommesseinrichtung (10) und zum Test der allstromsensitiven Differenzstrommesseinrichtung (24) aufweist.

4. Fehlerstrom-Schutzeinrichtung (RCD) (2) zur allstromsensitiven Differenzstrommessung mit einem Leistungsschalter (14),
**gekennzeichnet durch**
eine spannungsabhängige Funktionseinheit (22) mit einer allstromsensitiven Differenzstrommesseinrichtung (24), bestehend aus einem Stromsensor (26) und einem allstromsensitiven Stromerfassungsmodul (28), und mit einem Mikrocontroller (30) zur Konfiguration der spannungsabhängigen Funktionseinheit (22) und zur Auswertung des von der allstromsensitiven Differenzstrommesseinrichtung (24) erfassten Differenzstroms, wobei die spannungsabhängige Funktionseinheit (22) eine gesteuerte Prüfeinrichtung (48) zum Test der allstromsensitiven Differenzstrommesseinrichtung (24) aufweist.

5. Fehlerstrom-Schutzeinrichtung (RCD) (2) nach einem der Ansprüche 1 bis 4,
**dadurch gekennzeichnet,**
**dass** die spannungsabhängige Funktionseinheit (22) eine digitale Programmierschnittstelle (34) zur Voreinstellung von Konfigurationsparametern während des Herstellungsprozesses der Fehlerstrom-Schutzeinrichtung (RCD) (2) aufweist.

6. Fehlerstrom-Schutzeinrichtung (RCD) (2) nach einem der Ansprüche 1 bis 5,
**dadurch gekennzeichnet,**
**dass** die spannungsabhängige Funktionseinheit (22) eine digitale Kommunikationsschnittstelle (36) zur Datenübertragung aufweist.

7. Fehlerstrom-Schutzeinrichtung (RCD) (2) nach einem der Ansprüche 1 bis 6,
**dadurch gekennzeichnet,**
**dass** die spannungsabhängige Funktionseinheit (22) eine Anzeigeeinrichtung (38) zur Darstellung des erfassten Differenzstroms aufweist.

8. Fehlerstrom-Schutzeinrichtung (RCD) (2) nach einem der Ansprüche 1 bis 7,
**dadurch gekennzeichnet,**
**dass** die spannungsabhängige Funktionseinheit (22) eine Stromquelle (50) zur Bereitstellung eines Teststroms für die gesteuerte Prüfeinrichtung (48) oder für die gemeinsame, gesteuerte Prüfeinrichtung (52) aufweist.

9. Fehlerstrom-Schutzeinrichtung (RCD) (2) nach einem der Ansprüche 1 bis 8,
**dadurch gekennzeichnet,**
**dass** die spannungsabhängige Funktionseinheit (22) eine Bedieneinheit (40) zur Eingabe von Daten und zur manuellen Ablaufsteuerung aufweist.

10. Fehlerstrom-Schutzeinrichtung (RCD) (2) nach einem der Ansprüche 1 bis 9,
**dadurch gekennzeichnet,**
**dass** die spannungsabhängige Funktionseinheit (22) eine Treiberschaltung (44) und eine Schaltstufe (46) zur Weiterleitung eines Auslösesignals an den Leistungsschalter (14) aufweist.

11. Fehlerstrom-Schutzeinrichtung (RCD) (2) nach einem der Ansprüche 1 bis 10,
**dadurch gekennzeichnet,**
**dass** die spannungsabhängige Funktionseinheit (22) Signalisierungseinrichtungen (41) zur Signalisierung von Warnungen und Betriebszuständen aufweist.

12. Fehlerstrom-Schutzeinrichtung (RCD) (2) nach einem der Ansprüche 1 bis 11,
**dadurch gekennzeichnet,**
**dass** die spannungsabhängige Funktionseinheit (22) einen Schaltsignalausgang (42) zur Ausgabe mindestens eines programmierbaren Schaltsignals aufweist.

13. Verfahren zur allstromsensitiven Differenzstrommessung, umfassend eine spannungsunabhängige, pulsstromsensitive Differenzstrommessung, eine Leistungsabschaltung und eine Prüfung der pulsstromsensitiven Differenzstrommesseinrichtung,
**dadurch gekennzeichnet,**
**dass** eine allstromsensitive Differenzstrommessung durch eine spannungsabhängige Funktionseinheit (22) mit einer allstromsensitiven Differenzstrommesseinrichtung (24) erfolgt und mittels eines Mikrocontrollers (30) eine Konfiguration der spannungsabhängigen Funktionseinheit (22) sowie eine Auswertung des von der allstromsensitiven Differenzstrommesseinrichtung (24) erfassten Differenzstroms ausgeführt werden.

14. Verfahren nach Anspruch 13,
**dadurch gekennzeichnet,**
**dass** die Prüfung der spannungsunabhängigen, pulsstromsensitiven Differenzstrommesseinrichtung (10) spannungsunabhängig mittels einer separaten, manuell auslösbaren Prüfeinrichtung (16) erfolgt und dass eine Prüfung der allstromsensitiven Differenzstrommesseinrichtung (24) spannungsabhängig mittels einer gesteuerten Prüfeinrichtung (48) erfolgt.

15. Verfahren nach Anspruch 13,
**dadurch gekennzeichnet,**
**dass** eine gemeinsame, spannungsabhängige Prüfung der spannungsunabhängigen, pulsstromsensitiven Differenzstrommesseinrichtung (10) und der allstromsensitiven Differenzstrommesseinrichtung (24) mittels einer gemeinsamen, gesteuerten Prüfeinrichtung (52) erfolgt.

16. Verfahren zur allstromsensitiven Differenzstrommessung mit einer Leistungsabschaltung,
**dadurch gekennzeichnet,**
**dass** eine allstromsensitive Differenzstrommessung durch eine spannungsabhängige Funktionseinheit (22) mit einer allstromsensitiven Differenzstrommesseinrichtung (24) erfolgt und mittels eines Mikrocontrollers (30) eine Konfiguration der spannungsabhängigen Funktionseinheit (22) sowie eine Auswertung des von der allstromsensitiven Differenzstrommesseinrichtung (24) erfassten Differenzstroms ausgeführt werden und dass eine Prüfung der allstromsensitiven Differenzstrommesseinrichtung (24) spannungsabhängig mittels einer gesteuerten Prüfeinrichtung (48) erfolgt.

17. Verfahren nach einem der Ansprüche 13 bis 16,
**dadurch gekennzeichnet,**
**dass** die Konfiguration der spannungsabhängigen Funktionseinheit (22) eine Einstellung der Funktionsparameter Ansprechwert, Zeitverzögerung sowie eine Parametrierung der Auslösecharakteristik umfasst.

18. Verfahren nach einem der Ansprüche 13 bis 17,
**dadurch gekennzeichnet,**
**dass** eine Eingabe von Konfigurationsparametern mittels einer digitalen Programmierschnittstelle (34) zur Voreinstellung von Konfigurationsparametern während des Herstellungsprozesses der Fehlerstrom-Schutzeinrichtung (RCD) (2) erfolgt.

19. Verfahren nach einem der Ansprüche 13 bis 18,
**dadurch gekennzeichnet,**
**dass** eine Datenübertragung mittels einer digitalen Kommunikationsschnittstelle (36) erfolgt.

20. Verfahren nach einem der Ansprüche 13 bis 19,
**dadurch gekennzeichnet,**
**dass** eine Darstellung des erfassten Differenzstroms mittels einer Anzeigeeinrichtung (38) erfolgt.

21. Verfahren nach einem der Ansprüche 13 bis 20,
**dadurch gekennzeichnet,**
**dass** ein Teststrom für die gesteuerte Prüfeinrichtung (48) oder für die gemeinsame, gesteuerte Prüfeinrichtung (52) durch eine Stromquelle (50) bereitgestellt wird.

22. Verfahren nach einem der Ansprüche 13 bis 21,
**dadurch gekennzeichnet,**
**dass** eine manuelle Dateneingabe und eine manuelle Ablaufsteuerung mittels einer Bedieneinheit (40) erfolgen.

23. Verfahren nach einem der Ansprüche 13 bis 22,
**dadurch gekennzeichnet,**
**dass** eine Weiterleitung eines Auslösesignals an den Leistungsschalter (14) mittels einer Treiberschaltung (44) und einer Schaltstufe (46) erfolgt.

24. Verfahren nach einem der Ansprüche 13 bis 23,
**dadurch gekennzeichnet,**
**dass** die Auswertung des von der allstromsensitiven Differenzstrommesseinrichtung (24) erfassten Differenzstroms mittels des Mikrocontrollers (30) einen oder mehrere der folgenden Schritte umfasst:
- eine Effektivwertberechnung,
- einen Schwellwertvergleich mit Erzeugung des Auslösesignals,
- die Signalisierung von Warnungen und Betriebszuständen,
- eine Erzeugung und Ausgabe von programmierbaren Schaltsignalen.
